# EUROPEAN PATENT APPLICATION

(11) **EP 2 679 707 A1**
(43) Date of publication of application: **01.01.2014**
(21) Application number: 13174179.5
(22) Date of filing: 28.06.2013
(51) Int. Cl.: C30B 25/02, C30B 25/16, C30B 29/40, H01L 21/02

(54) **Method of manufacturing gallium nitride substrate and gallium nitride substrate manufactured by the same**

(30) Priority: 29.06.2012 KR 20120070389; 18.12.2012 KR 20120147987
(71) Applicant: Samsung Corning Precision Materials Co., Ltd., Gyeongsangbuk-do Gumi-si, 730-735 (KR)
(72) Inventor: Lim, SungKeun, 336-841 Asan-si (KR); Park, Boik, 336-841 Asan-si (KR); Woo, Kwang-Je, 336-841 Asan-si (KR); Kim, Woorihan, 336-841 Asan-si (KR); Kim, Joon Hoi, 336-841 Asan-si (KR); Park, CheolMin, 336-841 Asan-si (KR); Bae, JunYoung, 336-841 Asan-si (KR); Lee, DongYong, 336-841 Asan-si (KR); Lee, WonJo, 336-841 Asan-si (KR); Choi, JunSung, 336-841 Asan-si (KR)
(74) Representative: Gulde Hengelhaupt Ziebig & Schneider

(57) **Abstract**

A method of manufacturing a gallium nitride (GaN) substrate and a GaN substrate manufactured by the same. The method includes the steps of growing a GaN film on a base substrate and separating the base substrate from the GaN film. The step of growing the GaN film includes forming pits in the GaN film, the pits inducing an inversion domain boundary to be formed inside the GaN film. The GaN substrate can have a predetermined thickness with which it can be handled during layer transfer (LT) processing, and the warping of the GaN substrate can be minimized, thereby preventing cracks due to warping.

## Description

### CROSS REFERENCE TO RELATED APPLICATION

The present application claims priority from Korean Patent Application Numbers 10-2012-0070389 and 10-2012-0147987 filed on June 29, 2012 and December 18, 2012, respectively, the entire contents of which application are incorporated herein for all purposes by this reference.

### BACKGROUND OF THE INVENTION

### Field of the Invention

The present invention relates to a method of manufacturing a gallium nitride (GaN) substrate and a GaN substrate manufactured by the same, and more particularly, to a method of manufacturing a GaN substrate and a GaN substrate manufactured by the same, in which the GaN substrate can have a predetermined thickness with which it can be handled during layer transfer (LT) processing, and the warping of the GaN substrate can be minimized, thereby preventing cracks due to the warping.

### Description of Related Art

Gallium nitride (Ga) is a direct transition semiconductor material having band gap energy of 3.39 eV, and is available for the fabrication of a light-emitting device (LED) that emits light in a short wavelength range. However, it is difficult to mass-produce GaN single crystals, since a high temperature of 1,500 °C or higher and a nitrogen atmosphere of 20,000 atms are required for growing liquid crystals due to the high nitrogen vapor pressure at a melting point. In addition, it is difficult to manufacture GaN by a liquid phase epitaxy (LPE), since a thin panel type crystal that is currently available has a size of about 100 mm².

Gallium nitride (GaN) is a direct transition semiconductor material that has a band gap energy of 3.39eV and is available for the fabrication of light-emitting devices (LEDs) that emit light having a short wavelength. It is difficult to mass-produce GaN single crystals, since a high temperature of 1,500 °C or higher and a nitrogen atmosphere of 20,000 atms are required for growing liquid crystals due to the high nitrogen vapor pressure at its melting point. In addition, it is difficult to manufacture GaN by LPE, since a thin panel type crystal having a size of about 100 mm² is currently available.

Accordingly, a GaN film or substrate was grown on a heterogeneous substrate using a vapor phase growth method, such as metal organic chemical vapor deposition (MOCVD) or hydride vapor phase epitaxy (HVPE). Here, MOCVD is not applicable to the manufacture of a GaN substrate having a thickness of tens to hundreds of micrometers because of a very slow growth rate thereof even though MOCVD can produce a high-quality film. For this reason, HVPE is mainly used for the manufacture of a GaN thin film since high-speed growth is possible in HVPE.

In addition, a sapphire substrate is most popular as a base substrate that is used for the manufacture of a GaN substrate because it has a hexagonal system like GaN, is inexpensive, and is stable at high temperatures. However, a difference (about 16%) in the lattice constant and a difference (about 35%) in the coefficient of thermal expansion between the sapphire and the GaN induce a strain at the interface between the sapphire and the GaN, which in turn creates lattice defects, warping and cracks in the crystal. This consequently makes it difficult to grow a high-quality GaN substrate. Here, the lattice constant of GaN a_{[1100]} is 5.521 Å, whereas the lattice constant of sapphire is 4.759 Å. Since the lattice constant of GaN is greater than the lattice constant of sapphire, the GaN film is subjected to compressive stress and the sapphire substrate is subjected to tensile stress, so that the GaN film and the sapphire substrate tend to cause a warping structure that is convex upward.

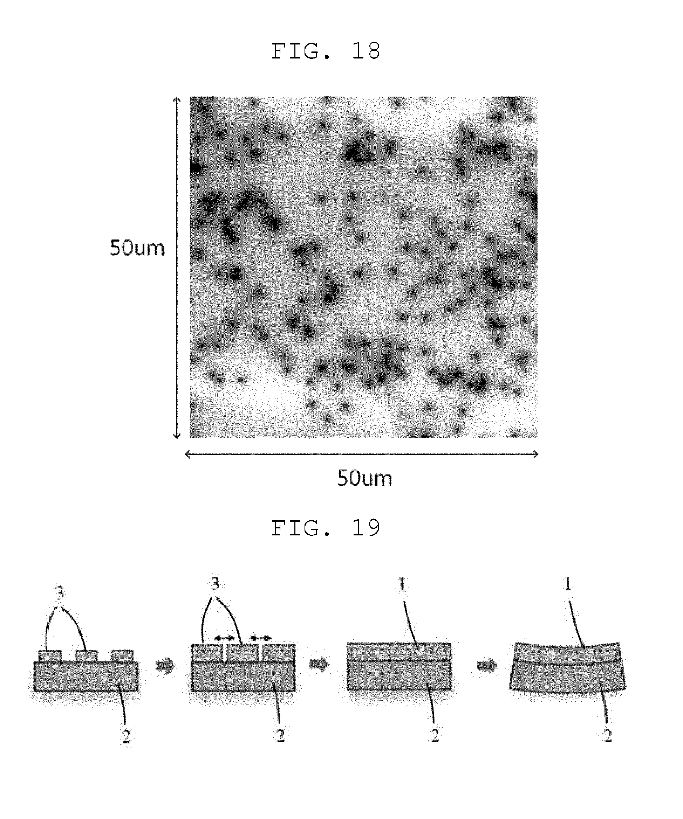

As shown in FIG. 19, when a GaN film 1 is grown on a sapphire substrate 2, the GaN film 1 grows in the shape of GaN islands 2 on the sapphire substrate 2 due to the difference in the lattice constants and surface energy between GaN and sapphire. (a) When the GaN film is continuously grown in this state, the GaN islands 3 are individually grown. (b) The GaN islands 3 finally merge together, thereby being converted into the shape of a film. (c) The GaN islands 3 merge together since the amount of surface energy that is decreased by island merging exceeds the amount of strain energy that is generated by the growth of the GaN islands 3. In this case, due to tensile stress that is applied by the growth of the GaN islands 3, the GaN film 1 and the sapphire substrate 2 tend to cause a warping structure that is concave downward (with respect to the paper surface).

In this fashion, GaN and sapphire are subjected to both forces that act in the opposite directions, i.e. the force that warps the substrate into the convex shape due to the difference between the lattice constants and the force that warps the substrate into the concave shape due to the growth of GaN. The final force that is applied to GaN and sapphire is determined by the sum of the two forces. In general, the sapphire substrate and the GaN film grown thereon finally has the concavely-warped structure, since the force that warps the substrate into the concave shape due to the growth of GaN is greater.

Here, after the sapphire substrate is separated from the GaN film in order to manufacture a freestanding GaN substrate, the warping that has been generated during the growth of the GaN film in this fashion is directly reflected on the freestanding GaN substrate. Accordingly, the warping deteriorates the characteristics and the yield of devices which are fabricated on the GaN substrate. When the GaN substrate is used for layer transfer (LT) or the like, the warping causes uniform bonding between a GaN thin film separated from the GaN substrate and a support substrate which reinforces the strength of the GaN thin film to be difficult, thereby making it difficult to obtain a bonding area.

In order to overcome this, in the related art, a low-quality GaN film is formed as a stress-reducing layer on the sapphire substrate, and then a high-quality GaN thick film is formed on the low-quality GaN film. In this case, in the related art, the GaN substrate is grown such that its thickness is less than 300 µm, since cracks occur when the total thickness of the GaN substrate is 300 µm or greater.

At this time, in order for the GaN substrate having this multilayer structure to be used as a layer transfer (LT) substrate, the full width at half maximum (FWHM) of an X-ray diffraction (XRD) rocking curve of the N-side (002) face is required to be 100 arcsec or less. For this, the low-quality GaN film having low crystalline quality is removed. However, when the low-quality GaN film is removed, the thickness of the left high-quality GaN film becomes 200 µm or less, where it is difficult to handle the GaN film, which is problematic. This is also a reason that creates cracks during LT processing.

The information disclosed in the Background of the Invention section is provided only for better understanding of the background of the invention, and should not be taken as an acknowledgment or any form of suggestion that this information forms a prior art that would already be known to a person skilled in the art.

### Related Art Document

Patent Document 1: Japanese Laid-Open Patent Publication No. 2001-122693 (May 8, 2001)

### BRIEF SUMMARY OF THE INVENTION

Various aspects of the present invention provide a method of manufacturing a gallium nitride (GaN) substrate and a GaN substrate manufactured by the same, in which the GaN substrate can have a predetermined thickness with which it can be handled during layer transfer (LT) processing, and the warping of the GaN substrate can be minimized, thereby preventing cracks due to warping.

In an aspect of the present invention, provided is a method of manufacturing a GaN substrate. The method includes the following steps of: growing a GaN film on a base substrate; and separating the base substrate from the GaN film. The step of growing the GaN film includes forming pits in the GaN film, the pits inducing an inversion domain boundary to be formed inside the GaN film.

According to an embodiment of the present invention, the step of growing the GaN film may include setting the content ratio of nitrogen to gallium at 20:1 or more, thereby increasing the density of the pits.

The step of growing the GaN film may include setting the growth temperature of the GaN film to be lower than 970 °C, thereby increasing a density of the pits.

The step of growing the GaN film may include growing a multilayer structure of the GaN film.

The step of growing the GaN film may include: growing a first GaN film on the base substrate; growing a second GaN film on the first GaN film, the content ratio of nitrogen to gallium of the second GaN film being smaller than the content ratio of nitrogen to gallium of the first GaN film; and growing a third GaN film on the second GaN film, the content ratio content of nitrogen to gallium of the third GaN film being larger than the content ratio of nitrogen to gallium of the second GaN film.

The step of separating the base substrate may use the first GaN film as a separation-boundary film.

The method may further include removing the first GaN film after the step of separating the base substrate.

The first GaN film may be grown by setting the content ratio of nitrogen to gallium at 20:1 or more, and the third GaN film may be grown by setting the content ratio of nitrogen to gallium at 20:1 or more.

The second GaN film may be grown by setting the content ratio of nitrogen to gallium at 2:1 or less.

In the step of growing the third GaN film, the third GaN film may be grown to a thickness that is greater than the thickness of the first GaN film and greater than the thickness of the second GaN film.

The method may further include the step of completely removing the first GaN film and partially removing the second GaN film after the step of separating the base substrate.

The method may further include the step of partially removing the third GaN film after the step of separating the base substrate.

In the step of partially removing the third GaN film, the second GaN film and the third GaN film may be partially removed such that a total of the thickness of the partially removed second GaN film and the thickness of the partially removed third GaN film ranges from 200 to 400 µm.

The second GaN film may be grown at a lower growth rate than the first GaN film and the third GaN film.

The second GaN film may be grown at a higher temperature than the first GaN film and the third GaN film.

In another aspect of the present invention, provided is a GaN substrate that includes: a first GaN film; and a second GaN film layered on the first GaN film, the content ratio of nitrogen to gallium of the second GaN film being greater than the content ratio of nitrogen to gallium of the first GaN film.

The full width at half medium (FWHM) of an X-ray diffraction (XRD) rocking curve of the N face of the first GaN film may be 100 arcsec or less.

The FWHM of an XRD rocking curve of an N-face of the second GaN film may be 200 arcsec or more.

The thickness of the GaN substrate may range from 200 to 400 µm.

The warping of the GaN substrate may range from 200 to 300 µm.

According to embodiments of the present invention, it is possible to effectively control the warping of the freestanding GaN substrate that is manufactured by setting the density of pits formed in the GaN film at a predetermined value by controlling the growth process parameters of the GaN film. Accordingly, it is possible to reduce an off-angle, improve the transfer ratio during layer transfer (LT), and improve the characteristics and the yield of semiconductor devices which are based on the freestanding GaN substrate.

In addition, it is possible to realize a thickness with which the GaN substrate can be handled during LT processing by forming the GaN film structure in which the low-quality, high-quality and low-quality films are sequentially stacked on the base substrate.

Furthermore, it is possible to reduce the occurrence of cracks due to the warping of the GaN substrate during LT processing by minimizing the warping by adjusting the thickness of each layer.

In addition, when the GaN substrate having the low-quality/high-quality structure is manufactured, the occurrence of cracks can be reduced since the low-quality GaN film reduces the stress of the high-quality GaN film. At the same time, the low-quality GaN film can act as a carrier substrate. This can increase the number by which LT processing using the GaN substrate is repeated, thereby improving the efficiency of the process of manufacturing a GaN thin film-bonded substrate.

The methods and apparatuses of the present invention have other features and advantages which will be apparent from, or are set forth in greater detail in the accompanying drawings, which are incorporated herein, and in the following Detailed Description of the Invention, which together serve to explain certain principles of the present invention.

### BRIEF DESCRIPTION OF THE DRAWINGS

FIG. 1, FIG. 2 and FIG. 3 and FIG. 4 are schematic views sequentially showing the processes of a method of manufacturing a gallium nitride (GaN) substrate according to an embodiment of the present invention;

FIG. 5A, FIG. 5B and FIG. 5C are schematic views showing the warping characteristic depending on the density of pits formed on a GaN film;

FIG. 6A and FIG. 6B are electron microscopy pictures showing a change in the density of pits depending on the growth temperature;

FIG. 7A and FIG. 7B are electron microscopy pictures showing a change in the density of pits depending on the ratio of nitrogen to gallium;

FIG. 8A and FIG. 8B are electron microscopy pictures showing a change in the density of pits depending on the flow rate of a gallium source gas;

FIG. 9 is a flowchart showing a method of manufacturing a GaN substrate according to another embodiment of the present invention;

FIG. 10, FIG. 11, FIG. 12, FIG. 13, FIG. 14 and FIG. 15 are schematic views sequentially showing the processes of the method of manufacturing a GaN substrate according to another embodiment of the present invention;

FIG. 16 is a view showing the warping characteristic depending on a change in the thickness of a third GaN film according to another embodiment of the present invention;

FIG. 17A and FIG. 17B are graphs showing X-ray diffraction (XRD) rocking curves of the (002) and (102) faces of a GaN substrate manufactured by the method of manufacturing a GaN substrate according to another embodiment of the present invention;

FIG. 18 is a scanning electron microscopy cathodoluminescence (SEM-CL) image of a GaN substrate manufactured by the method of manufacturing a GaN substrate according to another embodiment of the present invention; and

FIG. 19 is schematic view showing the process in which a GaN film is grown according to the related art.

### DETAILED DESCRIPTION OF THE INVENTION

Reference will now be made in detail to a method of manufacturing a gallium nitride (GaN) substrate and a GaN substrate manufactured by the same according to the present invention, embodiments of which are illustrated in the accompanying drawings and described below, so that a person having ordinary skill in the art to which the present invention relates can easily put the present invention into practice.

Throughout this document, reference should be made to the drawings, in which the same reference numerals and signs are used throughout the different drawings to designate the same or similar components. In the following description of the present invention, detailed descriptions of known functions and components incorporated herein will be omitted when they may make the subject matter of the present invention unclear.

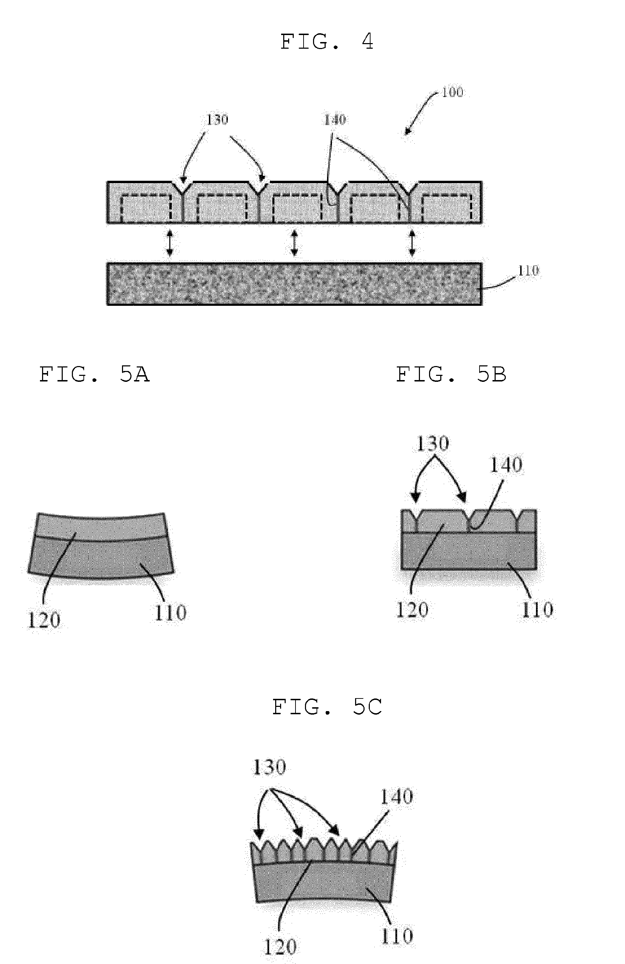

A method of manufacturing a GaN substrate according to an embodiment of the present invention is a method of manufacturing a freestanding GaN substrate (100 in FIG. 4) used for layer transfer (LT) or the like, and includes a GaN film growth step and a base substrate separation step.

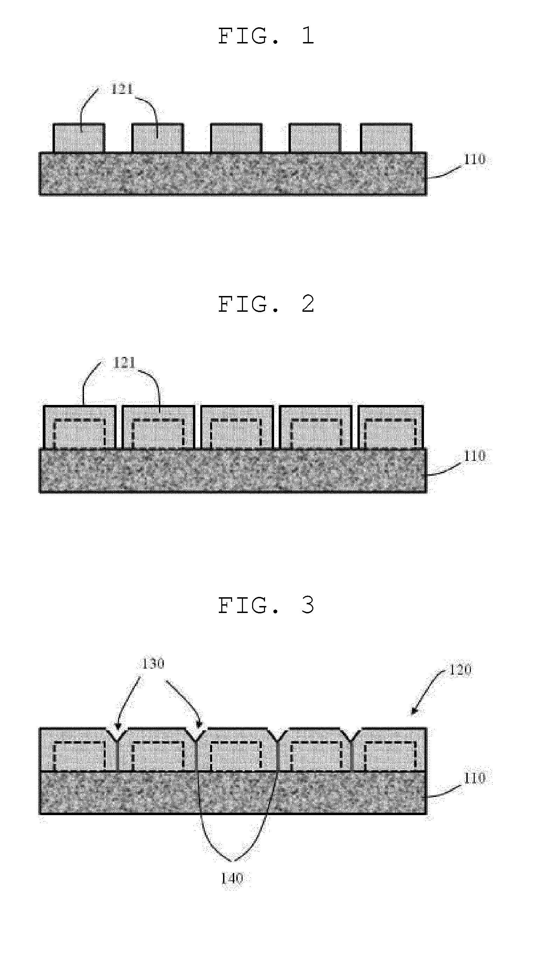

First as shown in FIG. 1 to FIG. 3, the GaN film growth step is the step of growing a GaN film 120 on a base substrate 110. According to an embodiment of the present invention, the GaN film growth step grows the GaN film 120 on the base substrate 110 via vapor phase epitaxy (VPE), such as hydride vapor phase epitaxy (HVPE). Specifically, the GaN film growth step grows the GaN film 120 by loading the base substrate 110 made of sapphire, Si, SiC, GaAs or the like on a susceptor inside a growth furnace, blowing a GaCl gas and a NH₃ gas, or source gases, into the growth furnace, and then heating the growth furnace so that the gases deposit on the base substrate 110.

Here, as shown in FIG. 1, when the GaN film 120 is grown via vapor deposition on the base substrate 110 which is made of, for example, sapphire, GaN islands 121 are initially grown on the base substrate 110 due to the difference in the lattice constant and surface energy between GaN and sapphire. Afterwards, as shown in FIG. 2, the GaN islands 121 separately grow, and then as shown in FIG. 3, the GaN islands 121 merge together, forming the GaN film 120. The GaN islands 121 merge together since the amount of surface energy that is decreased by island merging exceeds the amount of strain energy that is generated by the growth of the GaN islands.

As shown in FIG. 3, the GaN film growth step according to an embodiment of the present invention forms pits 130 in the GaN film 120, the pits 130 causing inversion domain boundaries 140 to be formed inside the GaN film 120, in particular, in boundaries at which adjacent islands of the GaN islands 121 meet.

When the pits 130 are formed in the GaN film 120, GaN grows in the direction toward the pole of N (to the right with respect to the paper surface) and in the direction toward the pole of S (to the left with respect to the paper surface), so that the inversion domain boundaries 140 that are boundaries in the direction toward the pole of N and in the direction toward the pole of Ga are formed under the pits 130.

When the pits 130 are present, that is, are formed while the GaN islands 121 are merging together, the inversion domain boundaries 140 cause the surface energy of the GaN islands 121 to be divided into inversion domain energy and tensile strain energy, so that the tensile stress is reduced from the case in which no pits 130 are present. Accordingly, the GaN film 120 is warped such that it has a less concave shape. In contrast, when no pits 130 are present, all of the surface energy is converted into the tensile strain energy.

Here, when the tensile stress is further reduced since a large number of pits 130 are present, the effect of compressive stress is increased due to the difference between the lattice constants, so that the GaN film 120 can be warped such that it has a convex shape. That is, the total area of the inversion domain boundaries 140 is increased as more pits 130 are formed in the GaN film 120. Accordingly, as the density of the pits 130 is increased, less surface energy of the GaN islands 121 is converted into the tensile strain energy. In addition, the merging of the GaN islands 121 causes the tendency to be warped into a convex shape to be stronger than the tendency to be warped into a concave shape.

FIG. 5A to FIG. 5C are schematic views showing the warping characteristic depending on the density of pits formed on a GaN film, in which FIG. 5A shows concave warping when the density of the pits 130 is low, FIG. 5C shows convex warping when the density of the pits 130 is high, and FIG. 5B shows the case where the density of the pits 130 is between those of FIG. 5A and FIG. 5C.

In this fashion, the warping characteristic or tendencies of the GaN film 120 can be determined by the density of the pits 130. At this time, the density of the pits 130 can be adjusted by controlling the growth process parameters of the GaN film 120.

Accordingly, the GaN film growth step according to an embodiment of the present invention increases the density of the pits 130 by controlling the growth temperature, the content ratio of nitrogen to gallium, the flow rate of a Ga source gas and the growth rate.

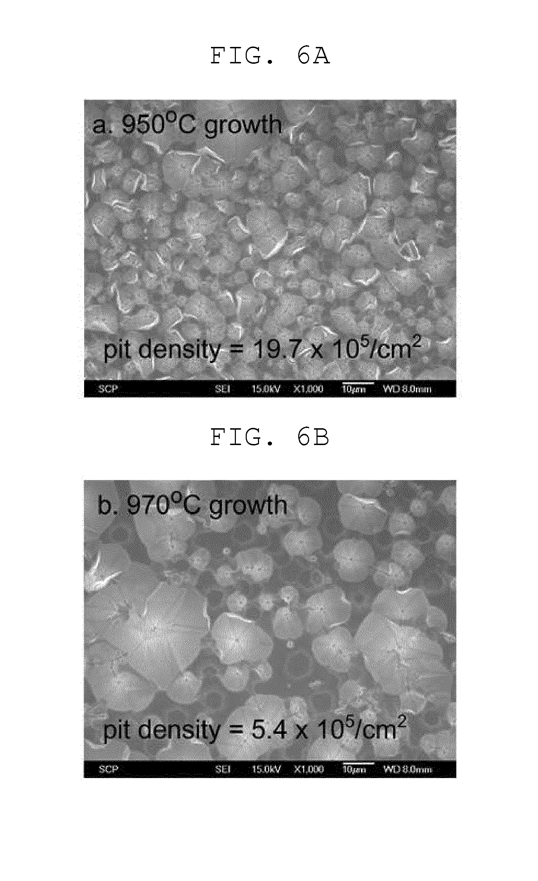

Thus, at the GaN film growth step, it is possible to control the growth temperature of the GaN film 120 to be less than 970 °C in order to increase the density of the pits 130. FIG. 6A and FIG. 6B are electron microscopy pictures showing a change in the density of pits depending on the growth temperature, in which FIG. 6A shows the case where the growth temperature is 950 °C, and FIG. 6B shows the case where the growth temperature is 970 °C. Comparing these figures, it is appreciated that the density of the pits in FIG. 6A which is grown at a lower temperature is about 4 times the density of the pits in FIG. 6B.

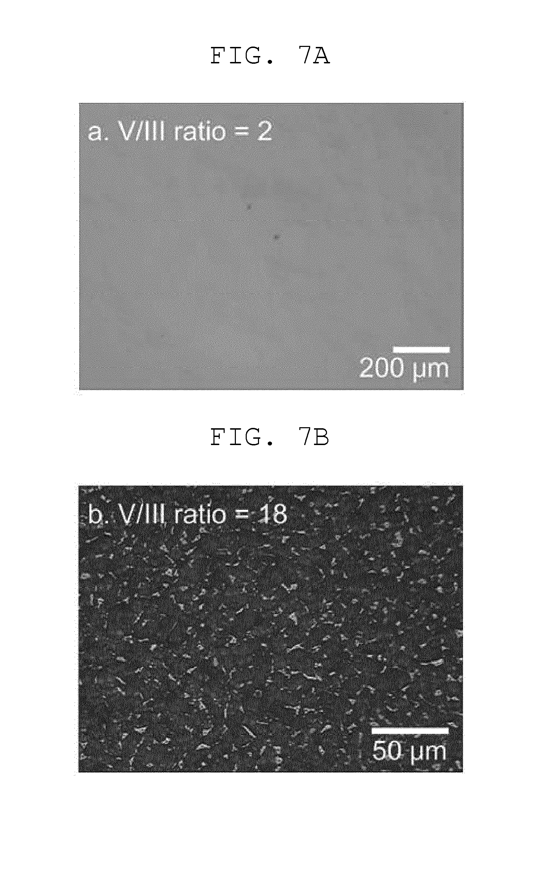

In addition, at the GaN film growth step, it is possible to set the content ratio of nitrogen to gallium in source gases that are supplied for the growth of the GaN film 120 such that the content ratio of nitrogen to gallium becomes 20:1 or greater in order to increase the density of the pits 130. FIG. 7A and FIG. 7B are electron microscopy pictures showing a change in the density of pits depending on the ratio of nitrogen to gallium, in which FIG. 7A shows the case where the ratio of nitrogen to gallium is 2, and FIG. 7B shows the case where the ratio of nitrogen to gallium is 18. Comparing these figures, it is appreciated that more pits are formed as the ratio of nitrogen to gallium is greater. Here, FIG. 7A and FIG. 7B show the tendency depending on the ratio of nitrogen to gallium, which is set at 20 or greater according to an embodiment of the present invention.

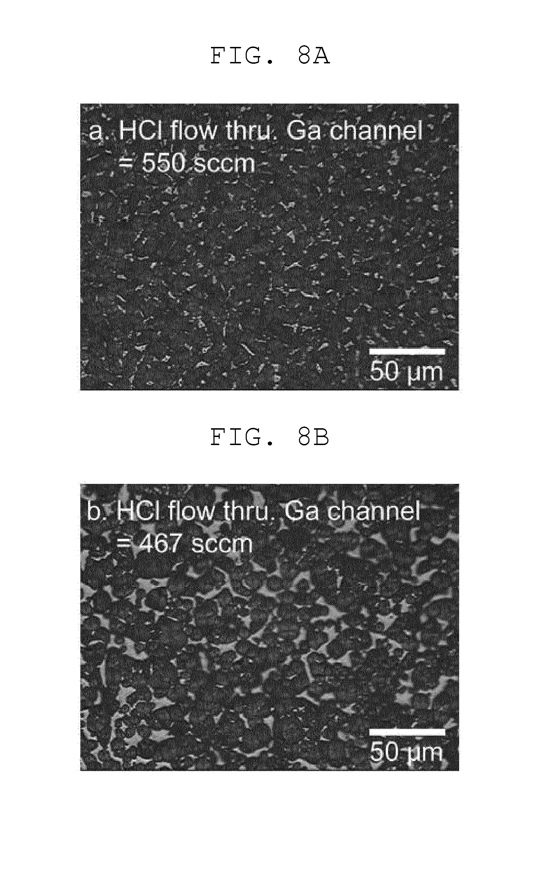

In addition, at the GaN film growth step, the flow rate of the GaCl gas can be increased in order to increase the density of the pits 130. FIG. 8A and FIG. 8B are electron microscopy pictures showing a change in the density of pits depending on the flow rate of a gallium source gas, in which FIG. 8A shows the case where the flow rate of the GaCl gas is 55 sccm, and FIG. 8B shows the case where the flow rate of the GaCl gas is 467 sccm. Comparing these figures, it is appreciated that the density of pits is increased as the flow rate of the gas is increased.

In addition, the GaN film growth step can rapidly grow the GaN film 120 in order to increase the density of the pits 130.

Afterwards, as shown in FIG. 4, the base substrate separation step is the step of separating the base substrate 110 from the GaN film 120. At the base substrate separation step, it is possible to separate the base substrate 110 by a laser lift-off technique. Specifically, when a laser beam is incident onto the interface between the base substrate 110 and the GaN film 120, the interface between the base substrate 110 and the GaN film 120 is ablated by the energy of the laser beam so that the base substrate 110 is separated from the GaN film 120.

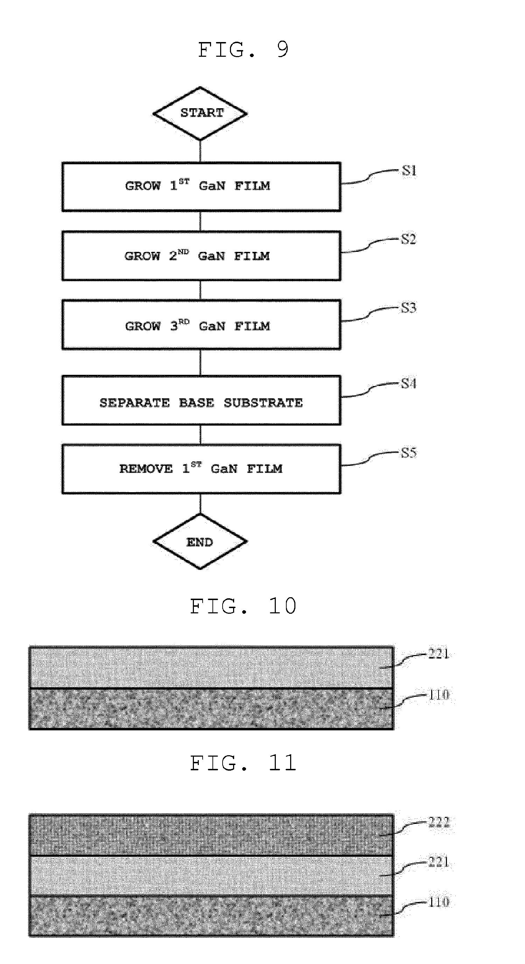

Reference will now be made in detail to a method of manufacturing a GaN substrate according to another embodiment of the present invention with reference to FIG. 9 to FIG. 18.

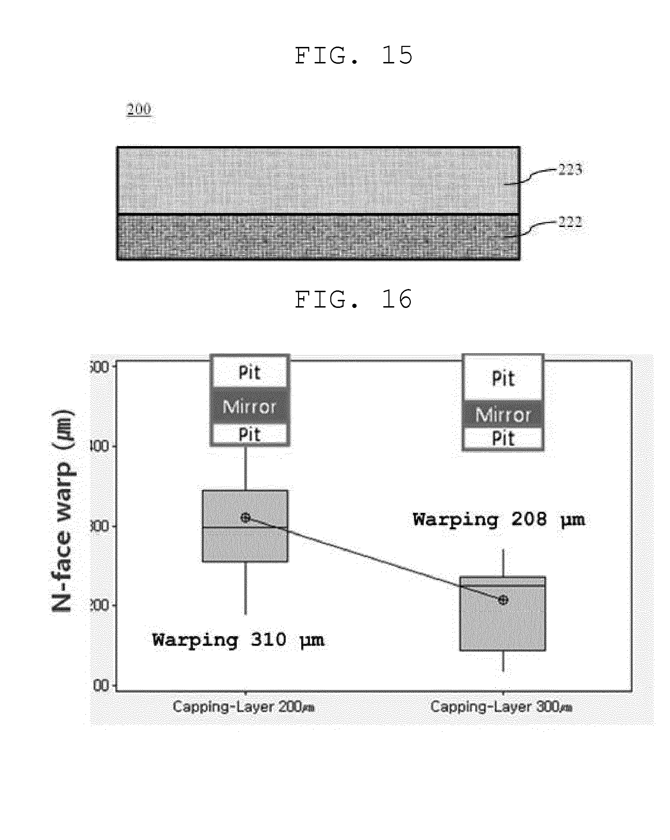

As shown in FIG. 9, the method of manufacturing a GaN substrate according to another embodiment of the present invention is the method of manufacturing a GaN substrate (200 in FIG. 15) having a multilayer structure unlike the method according to the former embodiment of the present invention, and includes a first GaN film growth step S1, a second GaN film growth step S2, a third GaN film growth step S3, a base substrate separation step S4 and a first GaN film removal step S5.

First, as shown in FIG. 10, the first GaN film growth step S1 is the step of growing a first GaN film 221 on a base substrate 110. The first GaN film growth step S1 grows the first GaN film 221 on the base substrate via VPE, such as HVPE. Specifically, the first GaN film growth step S1 grows the first GaN film 221 by loading the base substrate 110 made of sapphire, Si, SiC, GaAs or the like on a susceptor inside a growth furnace, blowing a GaCl gas and a NH₃ gas into the growth furnace, and then heating the growth furnace so that the gases deposit on the base substrate 110. In this case, it is preferred that the first GaN film 221 be grown at a lower temperature than a second GaN film 222 which will be grown at the subsequent process, for example, at a temperature below 970 °C. It is also preferred that the first GaN film 221 be grown at a faster rate than the second GaN film 222.

In addition, the first GaN film growth step S1 grows the first GaN film 221 by setting the content ratio of nitrogen to gallium in the gases that are supplied for the growth of the first GaN film 221 at 20:1 or greater. When the content ratio between nitrogen and gallium which forms the first GaN film 221 is set at 20:1 or greater, a number of pits which reduce stress is formed inside the first GaN film 221. The first GaN film 221 is configured such that the density of pits is higher than that of the second GaN film 222 which will be formed at the subsequent process. The full width at half maximum (FWHM) of an X-ray diffraction (XRD) rocking curve of the N-side (002) face, i.e. the surface which adjoins the base substrate 110, is 200 arcsec or greater. Here, the FWHM of the XRD rocking curve is a value with which crystallinity can be determined. A greater FWHM value indicates that more defects which lead to decreased crystallinity are present inside the thin film. This consequently indicates that the quality of the thin film is low. In this fashion, the first GaN film growth step S1 grows the low-quality first GaN film 221 by setting the content ratio of nitrogen to gallium to be rather high, so that the base substrate can be easily separated using the first GaN film 221 as a separation-boundary film at the subsequent process of the base substrate separation step S4.

In addition, at the first GaN film growth step S1, the first GaN film 221 can be grown to a thickness of, for example, 100 µm. The first GaN film 221 that is grown to this thickness is completely removed at subsequent processing.

In sequence, as shown in FIG. 11, the second GaN film growth step S2 is the step of growing the second GaN film 222 on the first GaN film 221. At this step, the second GaN film 222 is grown on the first GaN film 221 via VPE, such as HVPE, as in the process of growing the first GaN film 221. At this time, the second GaN film 222 is grown as a high-quality GaN film that has a microscopic structure unlike the first GaN film 221. That is, unlike the first GaN film 221, the second GaN film 222 has superior crystallinity that can be used during LT processing. For this, the second GaN film 222 is grown at a higher temperature than the first GaN film 221, for example, a temperature of 970 °C or higher, and at a slower growth rate than the first GaN film 221.

At the second GaN film growth step S2, the second GaN film 222 is grown such that the content ratio of nitrogen to gallium is lower than that of the first GaN film 221. Specifically, the second GaN film growth step S2 grows the second GaN film 222 by setting the content ratio of nitrogen to gallium in source gases that are supplied for the growth of the second GaN film 222 at 2:1 or smaller. When the content ratio between nitrogen and gallium which form the second GaN film 222 is set in the range, for example, from 1:1 to 2:1, the second GaN film 222 is formed such that defects, such as dislocation, are present at lower density than in the first GaN film 221. Consequently, the second GaN film 222 is grown as a high-quality GaN film having excellent crystallinity. Here, the FWHM of an XRD rocking curve of the N-side (002) face of the second GaN film 22 is 100 arcsec or less.

In the meantime, at the second GaN film growth step S2, the second GaN film 222 can be grown to a thickness, for example, 100 µm. A portion of the second GaN film 222 that is grown to this thickness can be removed together with the first GaN film 221 at subsequent processing of the first GaN film removal step S5. For example, the second GaN film 222 that is grown to a thickness of 100 µm can have about 30 µm removed from the surface thereof, thereby having a final thickness of 70 µm.

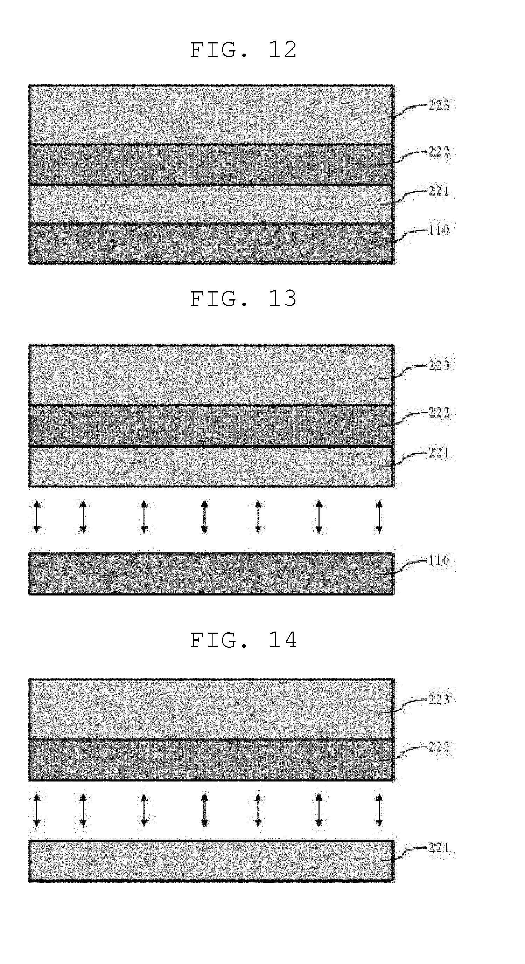

In sequence, as shown in FIG. 12, the third GaN film growth step S3 is the step of growing a third GaN film 223 on the second GaN film 222. At the third GaN film growth step S3, the third GaN film 223 is grown on the second GaN film 222 via VPE, such as HVPE, as in the process of growing the first GaN film 221 and the process of growing the second GaN film 222. The third GaN film 223 is a low-quality GaN film like the first GaN film 221. It is preferred that the third GaN film 223 be grown at a lower growth temperature than the second GaN film 222, for example, a temperature below 970 °C, and at a faster growth rate than the second GaN film 222.

In addition, the third GaN film growth step S3 grows the third GaN film 223 by setting the content ratio of nitrogen to gallium in source gases that are supplied for the growth of the third GaN film 223 at 20:1 or greater in order to grow the low-quality third GaN film 223. When the content ratio between nitrogen and gallium which form the third GaN film 223 is set at 20:1 or greater, a number of pits is formed inside the third GaN film 223, thereby forming the low-quality GaN film having low crystallinity.

Like the first GaN film 221, the third GaN film 223 serves to reduce stress in order to prevent cracks from forming. At this time, the first GaN film 221 serves to reduce stress during growth processing, and the third GaN film 223 serves to reduce stress during LT processing of a GaN substrate (200 in FIG. 15) which is produced after the growth of the third GaN film 223. That is, the third GaN film 223 together with the second GaN film 222 forms the GaN substrate (200 in FIG. 15). Here, the GaN substrate (200 in FIG. 15) must have a predetermined thickness with which it can be handled during LT processing. However, it is difficult to realize the predetermined thickness for LT processing since the growth thickness of the high-quality second GaN film 222 is limited. Accordingly, the low-quality third GaN film 223 is continuously grown on the second GaN film 222 so that the GaN substrate (200 in FIG. 15) can have a predetermined thickness with which it can be handled during LT processing. In this case, since the low-quality third GaN film 223 serves as a carrier substrate for the high-quality second GaN film 222, it does not have an effect on the quality of the GaN film that is transferred during LT processing.

As described above, the third GaN film growth step S3 can grow the third GaN film 223 to a thickness of, for example, 300 µm in order to complement the thickness of the second GaN film 222. Here, FIG. 16 is a view showing the warping characteristic depending on a change in the thickness of the third GaN film according to another embodiment of the present invention. When the third GaN film that acts as a capping layer was grown to a thickness of 200 µm, the warping of the N face became 310 µm. When the third GaN film that acts as the capping layer was grown to a thickness of 300 µm, the warping of the N face became 208 µm. Accordingly, it is appreciated that the warping is decreased as the thickness of the third GaN film 223 is increased.

The third GaN film 223 can be partially removed at subsequent processing. For instance, the third GaN film 223 which is grown to a thickness of 300 µm can be removed by about 70 µm from the surface thereof, thereby having a final thickness of 230 µm.

In sequence, as shown in FIG. 13, the base substrate separation step S4 is the step of separating the base substrate 110 using the first GaN film 221 as a separation-boundary film. At the base substrate separation step S4, it is possible to separate the base substrate 100 by a laser lift-off technique. Specifically, when a laser beam is incident onto the interface between the base substrate 110 and the first GaN film 221, the interface between the base substrate 110 and the first GaN film 221 is ablated by the energy of the laser beam so that the base substrate 110 is separated.

Next, as shown in FIG. 14, the first GaN film removal step S5 is the step of removing the first GaN film 221 from the multilayer structure that includes the second GaN film 222 and the third GaN film 223. At the first GaN film removal step S5, it is possible to remove the first GaN film 221 via grinding. When the first GaN film 221 is removed, a certain portion of the second GaN film 222 can be removed and a portion of the third GaN film 223 can also be removed. That is, according to another embodiment of the present invention, for instance, each of the first GaN film 221 and the second GaN film 222 is grown to a thickness of 100 µm, and the third GaN film 223 is grown to a thickness of 300 µm, so that a total thickness becomes 500 µm. Afterwards, the first GaN film 221 is completely removed, the second GaN film 222 has 30 µm removed, so that the resultant thickness becomes 70 µm, and the third GaN film 223 has 70 µm removed, so that the resultant thickness becomes 230 µm. Due to this processing, a total thickness of the second GaN film 222 and the third GaN film 223 becomes 300 µm.

As shown in FIG. 15, when the first GaN film removal step S5 is finished, the GaN substrate 200 that is realized by stacking the second GaN film 222 and the third GaN film 223 on each other is produced. That is, the GaN substrate 200 according to another embodiment of the present invention includes the high-quality second GaN film 222 and the low-quality third GaN film 223. In this case, the GaN substrate 200 can be formed at a thickness with which it can be handled during LT processing, for example, a thickness ranging from 200 to 400 µm, and preferably, a thickness of 300 µm. In addition, the warping of the GaN substrate 200 can range from 200 to 300 µm, and preferably, be 208 µm.

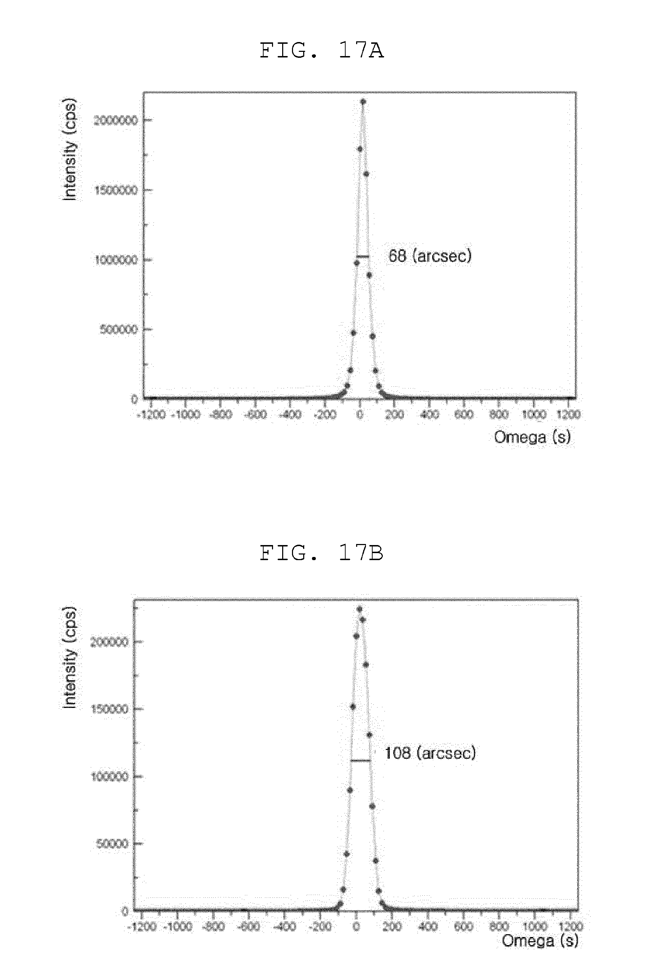

FIG. 17A and FIG. 17B are graphs showing XRD rocking curves of the (002) and (102) faces of the GaN substrate (200 in FIG. 15) manufactured by the method of manufacturing a GaN substrate according to another embodiment of the present invention. It was observed that the FWHM "a" of an XRD rocking curve of the N face, i.e. the (002) face, is 68 arcsec and the FWHM "b" of an XRD rocking curve of the Ga face, i.e. the (102) face, is 108 arcsec. Therefore, the GaN substrate (200 in FIG. 15) according to another embodiment of the present invention is configured such that the crystallinity of the N face is higher than the crystallinity of the Ga face.

Furthermore, FIG. 18 is a scanning electron microscopy cathodoluminescence (SEM-CL) image of the GaN substrate manufactured by the method of manufacturing a GaN substrate according to another embodiment of the present invention. This figure shows the density of defects in the N face, which was observed to be about 6.2X10⁶/cm².

The foregoing descriptions of specific exemplary embodiments of the present invention have been presented with respect to the drawings. They are not intended to be exhaustive or to limit the present invention to the precise forms disclosed, and obviously many modifications and variations are possible for a person having ordinary skill in the art in light of the above teachings.

It is intended therefore that the scope of the present invention not be limited to the foregoing embodiments, but be defined by the Claims appended hereto and their equivalents.

## Claims

1. A method of manufacturing a gallium nitride substrate comprising:
growing a gallium nitride film on a base substrate; and
separating the base substrate from the gallium nitride film,
wherein growing the gallium nitride film comprises forming pits in the gallium nitride film, the pits inducing an inversion domain boundary to be formed inside the gallium nitride film.

2. The method of claim 1,
wherein growing the gallium nitride film comprises setting a content ratio of nitrogen to gallium at 20:1 or more, thereby increasing a density of the pits, and/or
wherein growing the gallium nitride film comprises setting a growth temperature of the gallium nitride film to be lower than 970 °C, thereby increasing a density of the pits.

3. The method of claim 1, wherein growing the gallium nitride film comprises growing a multilayer structure of the gallium nitride film.

4. The method of claim 3, wherein growing the gallium nitride film comprises:
growing a first gallium nitride film on the base substrate;
growing a second gallium nitride film on the first gallium nitride film, a content ratio of nitrogen to gallium of the second gallium nitride film being smaller than a content ratio of nitrogen to gallium of the first gallium nitride film; and
growing a third gallium nitride film on the second gallium nitride film, a content ratio content of nitrogen to gallium of the third gallium nitride film being larger than the content ratio of nitrogen to gallium of the second gallium nitride film.

5. The method of claim 4, further comprising removing the first gallium nitride film after separating the base substrate.

6. The method of claim 4,
wherein the first gallium nitride film is grown by setting the content ratio of nitrogen to gallium at 20:1 or more, and the third gallium nitride film is grown by setting the content ratio of nitrogen to gallium at 20:1 or more, and/or
wherein the second gallium nitride film is grown by setting the content ratio of nitrogen to gallium at 2:1 or less.

7. The method of claim 4, wherein the third gallium nitride film is grown to a thickness that is greater than a thickness of the first gallium nitride film and greater than a thickness of the second gallium nitride film.

8. The method of claim 4, further comprising completely removing the first gallium nitride film and partially removing the second gallium nitride film after separating the base substrate.

9. The method of claim 8, further comprising partially removing the third gallium nitride film after separating the base substrate.

10. The method of claim 9, wherein the second gallium nitride film and the third gallium nitride film are partially removed such that a total of a thickness of the partially removed second gallium nitride film and a thickness of the partially removed third gallium nitride film ranges from 200 to 400 µm.

11. The method of claim 4, wherein the second gallium nitride film is grown at a lower growth rate than the first gallium nitride film and the third gallium nitride film.

12. The method of claim 4, wherein the second gallium nitride film is grown at a higher temperature than the first gallium nitride film and the third gallium nitride film.

13. A gallium nitride substrate comprising:
a first gallium nitride film; and
a second gallium nitride film layered on the first gallium nitride film, a content ratio of nitrogen to gallium of the second gallium nitride film being greater than a content ratio of nitrogen to gallium of the first gallium nitride film.

14. The gallium nitride substrate of claim 13, wherein a full width at half medium (FWHM) of an X-ray diffraction (XRD) rocking curve of an N face of the first gallium nitride film is 100 arcsec or less.

15. The gallium nitride substrate of claim 13, wherein a full width at half medium (FWHM) of an X-ray diffraction (XRD) rocking curve of an N face of the second gallium nitride film is 200 arcsec or more.
